# EUROPÄISCHE PATENTANMELDUNG

(11) **EP 2 101 241 A1**
(43) Veröffentlichungstag der Anmeldung: **16.09.2009**
(21) Anmeldenummer: 09003156.8
(22) Anmeldetag: 05.03.2009
(51) Int. Cl.: G05F 3/26

(54) **Treiberschaltung, Verfahren zum Betrieb und Verwendung eines Stromspiegels einer Treiberschaltung**

(30) Priorität: 13.03.2008 US 36446 P
(71) Anmelder: ATMEL Germany GmbH, 74072 Heilbronn (DE)
(72) Erfinder: Bergmann, Günther, Dr.-Ing., 89134 Blaustein (DE); Kolb, Peter, 89257 Illertissen (DE); Offenwanger, Michael, 89331 Burgau (DE); Vogelmann, Holger, 88477 Schwendi (DE)
(74) Vertreter: Müller, Wolf-Christian

(57) **Zusammenfassung**

Treiberschaltung (10), Verfahren zum Betrieb und Verwendung eines Stromspiegels einer Treiberschaltung (10)
- mit zumindest einem Ausgangstransistor (100),
- mit einem Referenznetzwerk (200) mit zumindest einem Referenztransistor (210),
- mit einer Schaltvorrichtung (300), die mit dem Steuereingang (G100) des Ausgangstransistors (100) und mit dem Steuereingang (G210) des Referenztransistors (210) zur Ausbildung eines schaltbaren Stromspiegels verbunden ist,
- mit einer Stromquelle (290) zur Bereitstellung eines Referenzstromes (Iref) für einen Referenzstrompfad (280), wobei die Stromquelle (290) und der Referenztransistor (210) im Referenzstrompfad (280) angeordnet sind,
- mit einem Lastanschluss (110), wobei der Lastanschluss (110) und der Ausgangstransistor (100) in einem Laststrompfad (180) angeordnet sind, und
- mit zumindest einem Dämpfungsnetzwerk (400, 500), das mit dem Referenzstrompfad (290) verbunden oder verbindbar ist,
- bei der eine Verschaltung von Bauelementen des zumindest einen Dämpfungsnetzwerkes (400, 500) und eine Verschaltung von Bauelementen des Referenznetzwerkes (200) im Wesentlichen gleich sind.

## Beschreibung

Die Erfindung betrifft eine Treiberschaltung, ein Verfahren zum Betrieb einer Treiberschaltung und eine Verwendung eines Stromspiegels.

Aus der JP 2001 036187 A ist eine Treiberschaltung für eine Laserdiode bekannt. Der zu treibende Laststrom wird durch ein differentielles Paar von Transistoren und einer anschließenden Verstärkung mit einem Stromspiegel generiert.

Aus der EP 1 478 063 D1 ist eine Treiberschaltung zum Betreiben eines elektronischen Bauteils bekannt. Die Treiberschaltung treibt einen Strom der in gesteuerter Weise zwischen wenigstens zwei diskreten Stromstärken umgesteuert wird. Die Treiberschaltung weist eine Stromspiegelschaltung mit einem Referenztransistor und mit einem mit dem Ausgang verbundenen weiteren Transistor auf. Die Treiberschaltung ist dabei zur Realisierung eines frequenzabhängigen Spiegelfaktors ausgebildet. Hierdurch wird die effektive Kollektorbasiskapazität der Treiberschaltung verringert. Hierzu ist der mit dem Ausgang verbundene weitere Transistor mit einem Widerstand und einer Induktivität in Reihe geschaltet.

Aus der DE 10 2005 022 612 A1 ist eine Treiberschaltung für elektronische Bauteile bekannt. Dabei ist ein Verstärker vorgesehen, der aus einem Referenzsignal ein Steuersignal erzeugt. Weiterhin sind ein Treiberstromspiegel und ein zwischen dem Verstärker und dem Treiberstromspiegel angeordneter Steuersignalschalter vorgesehen. Der Steuersignalschalter verbindet den Verstärker wahlweise mit dem Treiberstromspiegel oder trennt diese. Der Verstärker ist mit einer Kompensationsschaltung verbunden, die zusammen mit dem Verstärker eine geregelte Stromquelle bereitstellt.

Aus der US 2007-0253313 A1 sind ein Lasertreiber und ein Verfahren zum Treiben des Lasers sowie eine Aufnahme und Lesevorrichtung bekannt. Aus der EP 0 810 700 A2 ist ebenfalls eine Treiberschaltung für eine Laserdiode bekannt. Seriell geschaltete Dämpfungsschaltkreise reduzieren ein Überschwingen des Stroms durch die Laserdiode, wobei das Überschwingen durch drei unterschiedliche miteinander gekoppelte Resonanzen verursacht wird.

Der Erfindung liegt die Aufgabe zugrunde eine Treiberschaltung möglichst zu verbessern.

Diese Aufgabe wird durch eine Treiberschaltung mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist eine Treiberschaltung mit zumindest einem Ausgangstransistor vorgesehen. Weiterhin weist die Treiberschaltung ein Referenznetzwerk mit zumindest einem Referenztransistor auf. Der Ausgangstransistor und der Referenztransistor bilden im verbundenen Zustand einen Stromspiegel. Vorzugsweise ist ein Übersetzungsverhältnis des Stromspiegels, also ein Verhältnis eines Laststromes durch den Ausgangstransistor zu einem Referenzstrom durch den Referenztransistor größer 1, so dass der Laststrom den Referenzstrom übersteigt. Bevorzugt ist dabei vorgesehen, dass sowohl der Referenztransistor als auch der Ausgangstransistor Feldeffekttransistoren sind. Das Referenznetzwerk weist mehrere zu einem Netzwerk verschaltete Bauelemente auf. Eines dieser Bauelemente ist der Referenztransistor. Insbesondere in seiner Funktion als Bestandteil des Stromspiegels weist der Referenztransistor vorteilhafterweise eine Referenzspannung an seinem Steuereingang auf. Diese Referenzspannung kann mittels des Referenzstromes einstellbar sein, wobei ein zu treibender Laststrom durch den Ausgangstransistor von dieser Referenzspannung abhängig ist.

Weiterhin weist die Treiberschaltung eine Schaltvorrichtung auf, die mit einem Steuereingang des Ausgangstransistors und mit einem Steuereingang des Referenztransistors zur Ausbildung eines schaltbaren Stromspiegels verbunden ist. Vorzugsweise ist die Schaltvorrichtung dabei an den Referenztransistor und an den Steuereingang des Ausgangstransistors angeschlossen. Der Steuereingang des Ausgangstransistors ist vorzugsweise ein Gate des Ausgangstransistors als Feldeffekttransistor. Der Steuereingang des Referenztransistors ist ebenfalls vorzugsweise ein Gate des Referenztransistors als Feldeffekttransistor. Die Schaltvorrichtung verbindet in einem eingeschalteten Zustand die Steuereingänge des Ausgangstransistors und des Referenztransistors miteinander leitend. Der Ausgangstransistor und der Referenztransistor wirken in diesem eingeschalteten Zustand als Stromspiegel mit einem durch die Geometrien der Transistoren festgelegten Übersetzungsverhältnis des Stromspiegels. Im ausgeschalteten Zustand trennt die Schaltvorrichtung die Steuereingänge des Ausgangstransistors und des Referenztransistors. Hierdurch wird der Laststrom durch den Ausgangstransistor abgeschaltet. Ist in einem Ausführungsbeispiel der Ausgangstransistor als MOS-Feldeffekttransistor ausgebildet, kann es vorteilhaft sein, den Steuereingang (Gate-Elektrode) des Ausgangstransistors zusätzlich - beispielsweise über einen Widerstand - zu entladen.

Die Treiberschaltung weist weiterhin eine Stromquelle zur Bereitstellung eines Referenzstromes für einen Referenzstrompfad auf. Die Stromquelle und der Referenztransistor des Referenznetzwerkes sind im Referenzstrompfad angeordnet. Unter der Stromquelle wird dabei je nach Flussrichtung der Elektronen bzw. Löcher eine Quelle oder Senke verstanden. Vorzugsweise ist die Stromquelle einstellbar ausgebildet, wobei mittels eines analogen oder digitalen Einstellsignals der Referenzstrom eingestellt wird. Vorteilhafterweise ist die Stromquelle dabei derart ausgebildet, dass der Referenzstrom mit einer möglichst geringen Empfindlichkeit bezüglich der Temperatur der Treiberschaltung und Versorgungsspannungsschwankungen bereitgestellt wird. Beispielsweise ist die Stromquelle schaltbar mit einer externen oder Treiberschaltungs-internen Stromquelle beispielsweise über einen weiteren - beispielsweise schaltbaren - Stromspiegel gekoppelt.

Im stationären Zustand fließt der überwiegende Teil des Referenzstromes durch den Referenzstrompfad und damit durch den Referenztransistor. Im dynamischen Fall, wenn sich der Laststrom durch den Ausgangstransistor signifikant ändert, können zudem insbesondere Verschiebungsströme in den Referenzstrompfad an Verbindungsknoten zu oder abfließen. Der Referenzstrompfad ist durch die angeordneten Bauelemente und Verbindungen definiert, durch die der überwiegende Teil des Referenzstromes fließt. Der Referenzstrompfad kann zusätzlich zu den genannten Bauelementen wie den Referenztransistor und der Stromquelle auch parasitäre Bauelemente beispielsweise Induktivitäten von Zuleitungen aufweisen.

Weiterhin weist die Treiberschaltung einen Lastanschluss auf. Der Lastanschluss und der Ausgangstransistor sind in einem Laststrompfad angeordnet. Der Lastanschluss ist beispielsweise ein Pin oder ein Pad eines integrierten Schaltkreises, in den die Treiberschaltung integriert ist. Mit dem Pin oder Pad ist somit eine Last - beispielsweise eine Laserdiode oder eine Leuchtdiode - verbindbar. Der Laststrompfad ist durch die Bauelemente und Verbindungen definiert, die vom überwiegenden Teil des Laststromes durchflossen werden.

Mit dem Referenzstrompfad ist zumindest ein Dämpfungsnetzwerk der Treiberschaltung verbunden oder verbindbar. Zur Verbindung ist das Dämpfungsnetzwerk vorzugsweise an zumindest einen Knoten im Referenzpfad angeschlossen. Alternativ ist das Dämpfungsnetzwerk an ein Schaltelement angeschlossen, wobei das Schaltelement wiederum an zumindest einen Knoten des Referenzpfades angeschlossen ist. Das Dämpfungsnetzwerk ist nicht dasselbe wie das Referenznetzwerk, jedoch vorteilhafterweise gleich ausgebildet. Das Dämpfungsnetzwerk dämpft eine Schwingungs- bzw. Überschwingungsneigung der Treiberschaltung selbst. Vorzugsweise sind ein oder mehrere Dämpfungsnetzwerke für unterschiedliche Dämpfungen oder für unterschiedliche Laststromamplituden oder für unterschiedliche Flankensteilheiten des Laststroms vorgesehen. Vorzugsweise ist das Dämpfungsnetzwerk mit zumindest einem Versorgungsspannungsanschluss der Treiberschaltung verbunden.

Besonders bevorzugt ist das Dämpfungsnetzwerk mit genau einem Knoten des Referenzstrompfades verbunden. Besonders bevorzugt ist mit dem Knoten ebenfalls die Stromquelle zur Bereitstellung des Referenzstroms verbunden. Das Dämpfungsnetzwerk ist mit dem Referenzstrompfad verbunden, indem eine feste leitende Verbindung, insbesondere metallische Leitbahn zwischen Dämpfungsnetzwerk und Referenzstrompfad vorgesehen ist. Alternativ ist das Dämpfungsnetzwerk mit dem Referenzstrompfad verbindbar, indem ein Schaltelement wie beispielsweise ein Feldeffekttransistor oder Bipolartransistor, ein einstellbarer Widerstand oder eine Sicherung zwischen dem Dämpfungsnetzwerk und dem Referenzstrompfad vorgesehen ist.

Der Erfindung liegt weiterhin die Aufgabe zugrunde, ein möglichst verbessertes Verfahren zum Betrieb einer Treiberschaltung anzugeben.

Diese Aufgabe wird durch das Verfahren mit den Merkmalen des unabhängigen Anspruchs 14 gelöst. Vorteilhafte Weiterbildungen sind Gegenstand von abhängigen Ansprüchen und in der Beschreibung enthalten.

Demzufolge ist ein Verfahren zum Betrieb einer Treiberschaltung vorgesehen. Bevorzugt ist die Treiberschaltung gemäß den voranstehenden Ausführungen ausgebildet. In dem Verfahren wird für eine vorgegebene Signalform eines zu treibenden Laststroms eine Dämpfung eingestellt. Die vorgegebene Signalform umfasst dabei vorzugsweise die Vorgabe einer Signalamplitude und/oder die Vorgabe einer Flankensteilheit des Signals und/oder einen Grad des Überschwingens des Signals und/oder einer Verzögerungszeit des Signals. Der zu treibende Laststrom wird dabei an einem Ausgang der Treiberschaltung bereitgestellt. Die Dämpfung reduziert dabei eine Schwingungs- bzw. Überschwingungsneigung einer Gesamtschaltung aus Treiberschaltung und Last.

Die Dämpfung wird dabei eingestellt, indem ein Referenzstrompfad mit zumindest einem Dämpfungsnetzwerk für die jeweilige Signalform des zu treibenden Laststroms verbunden wird. Der Referenzstrompfad ist dabei Bestandteil eines schaltbaren Stromspiegels. Die Verbindung erfolgt dabei mittels zumindest eines Verbindungselementes, das mit dem Referenzstrompfad und dem Dämpfungsnetzwerk verbunden ist. Zum Verbinden kann das zumindest eine Verbindungselement beispielsweise zwischen zwei Schaltzuständen umgeschaltet werden. Auch ist es möglich, zur Verbindung das zumindest eine Verbindungselement mittels eines Steuersignals auf eine Impedanz, insbesondere einen gewünschten Widerstandswert einzustellen. Das zumindest eine Verbindungselement ist vorzugsweise als einstellbarer Widerstand - insbesondere als Feldeffekttransistor - ausgebildet. Vorzugsweise ist der Stromspiegel mittels einer Schaltvorrichtung schaltbar, wobei ein Schaltsignal für die Schaltvorrichtung in Abhängigkeit von der Verbindung zwischen dem Referenzstrompfad und dem Dämpfungsnetzwerk gebildet wird.

Der Erfindung liegt weiterhin die Aufgabe zugrunde eine Verwendung eines Stromspiegels anzugeben. Diese Aufgabe wird durch eine Verwendung mit den Merkmalen des unabhängigen Anspruchs 15 gelöst. Vorteilhafte Weiterbildungen sind Gegenstand von abhängigen Ansprüchen und in der Beschreibung enthalten.

Demzufolge ist eine Verwendung eines schaltbaren Stromspiegels und zumindest eines Dämpfungsnetzwerkes zur Einstellung einer Signalform eines Laststromes durch einen Laststrompfad des schaltbaren Stromspiegels vorgesehen. Der Stromspiegel ist dabei mittels eines Schalttransistors schaltbar ausgebildet. Der schaltbare Stromspiegel ist Teil eines Referenzstrompfades und eines Laststrompfades. Weiterhin weist der Referenzstrompfad eine Stromquelle auf. Der Laststrompfad ist hingegen mit der Last verbunden. Der Schalttransistor schaltet eine Verbindung zwischen dem Referenzstrompfad und dem Laststrompfad. Der Schalttransistor verbindet in einem eingeschalteten Zustand zwei Transistoren des Stromspiegels miteinander leitend, so dass der Stromspiegel im eingeschalteten Zustand als solcher mit einem Übersetzungsverhältnis wirkt. Im ausgeschalteten Zustand trennt der Schalttransistor die beiden Transistoren des Stromspiegels wieder, so dass der Laststrom abgeschaltet wird.

Das Dämpfungsnetzwerk ist mit dem Referenzstrompfad und der Stromquelle verbunden oder verbindbar um die Signalform des Laststromes einzustellen. Bevorzugt ist das Dämpfungsnetzwerk mit dem Referenzstrompfad mittels eines aktiven Bauelementes, wie beispielsweise eines steuerbaren Widerstandes oder eines Halbleiterschalters verbindbar.

Die im Folgenden beschriebenen Weiterbildungen beziehen sowohl auf die Treiberschaltung als auch auf das Verfahren als auch auf die Verwendung.

Bevorzugt ist vorgesehen, dass alle Transistoren der Treiberschaltung Feldeffekttransistoren, insbesondere MOS-Feldeffekttransistoren sind.

Vorteilhafterweise sind alle Transistoren Bestandteil einer CMOS-Technologie. Vorzugsweise sind alle Bauelemente der Treiberschaltung auf einem Halberleiterchip monolytisch integriert.

In einer vorteilhaften Weiterbildung weisen das zumindest eine Dämpfungsnetzwerk und das Referenznetzwerk jeweils Bauelemente auf, wobei Verschaltungen der Bauelemente im Dämpfungsnetzwerk jenen Verschaltungen der Bauelemente im Referenznetzwerk gleichen. Vorteilhafterweise weisen das Referenznetzwerk und das Dämpfungsnetzwerk Bauelemente desselben Bauelementetyps auf. Vorteilhafterweise weisen das Dämpfungsnetzwerk und das Referenznetzwerk eine sich entsprechende Verschaltung ihrer Bauelemente auf. Hierzu weisen das Dämpfungsnetzwerk und das Referenznetzwerk die gleiche Anzahl von Bauelementen und Anschlüssen zwischen den Bauelementen auf. Bevorzugt ist dabei vorgesehen, dass die Stromdichten durch einander korrespondierende Bauelemente des Referenznetzwerkes und des Dämpfungsnetzwerkes sich gleichen. Vorzugsweise sind die Bauelemente des Referenznetzwerks und des Dämpfungsnetzwerks gepaart (engl.: matching). Vorzugsweise weist dabei das Dämpfungsnetzwerk zu jedem Transistor des Referenznetzwerkes einen gepaarten Transistor auf.

Gemäß einer besonders bevorzugten Weiterbildung weist die Treiberschaltung ein Steuerelement auf. Das Steuerelement ist zur Einstellung einer Dämpfung durch das zumindest eine Dämpfungsnetzwerk mit dem Dämpfungsnetzwerk und dem Referenznetzwerk verbunden. Vorzugsweise ist das Steuerelement an das Dämpfungsnetzwerk und an das Referenznetzwerk angeschlossen. Das Steuerelement weist dabei einen digitalen oder analogen Steuereingang auf. Das steuernde Element ist beispielsweise ein Schalter oder ein steuerbarer Widerstand.

Gemäß einer vorteilhaften Ausführungsvariante ist zumindest eine weitere Stromquelle mit dem zumindest einen Dämpfungsnetzwerk verbunden.

Vorzugsweise ist der durch die weitere Stromquelle bereitgestellte Strom an die Stromdichten im Dämpfungsnetzwerk angepasst.

In einer vorteilhaften Ausgestaltung weist das Referenznetzwerk einen als Sourcefolger oder Emitterfolger verbundenen ersten Transistor auf, dessen Steuereingang mit dem Referenzstrompfad und dessen Source oder Emitter mit dem Steuereingang des Referenztransistors verbunden sind. Vorteilhafterweise ist der erste Transistor vom gleichen Typ wie der Referenztransistor. Bevorzugt ist mit dem Emitter oder der Source des ersten Transistors eine Widerstandsvorrichtung verbunden, wobei die Widerstandsvorrichtung zudem mit einer Versorgungsspannung verbunden ist. Gemäß einer vorteilhaften Ausgestaltung ist der Steuereingang des ersten Transistors des Referenznetzwerkes mit der Stromquelle verbunden.

Gemäß einer bevorzugten Ausbildung ist vorgesehen, dass die Schaltvorrichtung einen ersten Schalttransistor aufweist. Der erste Schalttransistor ist mit dem Steuereingang des Ausgangstransistors und mit dem Steuereingang des Referenztransistors verbunden. Vorzugsweise weist der erste Schalttransistor eine Schaltstrecke auf, die den Steuereingang des Referenztransistors mit dem Steuereingang des Ausgangstransistors verbinden kann. Bevorzugt ist der erste Schalttransistor ein Feldeffekttransistor, wobei dessen Source oder Drain mit dem Steuereingang des Ausgangstransistors und wobei dessen Source oder Drain mit dem Steuereingang des Referenztransistors verbunden sind.

Bevorzugt weist die Schaltvorrichtung einen zweiten Schalttransistor auf. Der zweite Schalttransistor ist mit dem Steuereingang des Ausgangstransistors und mit einer Versorgungsspannung verbunden. Der zweite Schalttransistor ist dabei vorzugsweise derart verschaltet, dass seine Schaltstrecke den Steuereingang des Ausgangstransistors mit einer Versorgungsspannung verbinden kann. Vorzugweise ist ebenfalls auch der zweite Transistor als Feldeffekttransistor ausgebildet, wobei dessen Source oder Drain mit dem Steuereingang des Ausgangstransistors und wobei dessen Source oder Drain mit der Versorgungsspannung direkt oder über ein weiteres Bauelement indirekt verbunden ist. Das weitere Bauelement ist beispielsweise eine Induktivität.

In einer besonders bevorzugten Weiterbildung ist vorgesehen, dass die Treiberschaltung eine Signalformungsvorrichtung aufweist. Die Signalformungsvorrichtung ist zur Formung eines ersten Steuersignals und/oder eines zweiten Steuersignals für den ersten Schalttransistor respektive den zweiten Schalttransistor ausgebildet. Das geformte erste Steuersignal bzw. das geformte zweite Steuersignal bewirken dabei eine hierzu korrelierende Veränderung der Signalform des Laststromes. So führt beispielsweise eine flachere Flankensteilheit des Steuersignals des ersten Steuersignals für den ersten Schalttransistor zu einer entsprechend kleineren Flankensteilheit beim Einschaltvorgang des Laststromes.

Die Signalformungsvorrichtung ist hierzu mit dem Steuereingang des ersten Schalttransistors und/oder mit dem Steuereingang des zweiten Schalttransistors verbunden. Vorteilhafterweise ist die Signalformungsvorrichtung zur Einstellung der Flankensteilheit ausgebildet. Die Signalformungsvorrichtung ermöglicht es die Form des ersten Steuersignals und/oder des zweiten Steuersignals und/oder die Phasenverschiebung oder Verzögerung zwischen dem ersten Steuersignal und dem zweiten Steuersignal einzustellen.

Gemäß einer vorteilhaften Weiterbildung ist vorgesehen, dass das Referenznetzwerk ein erstes Widerstandselement aufweist. Das Widerstandselement ist im Referenzstrompfad angeordnet und mit dem Referenztransistor und dem Steuereingang des ersten Transistors verbunden. Gemäß einer anderen Weiterbildungsvariante die sowohl in Alleinstellung als auch in Kombination mit der zuvor genannten Weiterbildungsvariante möglich ist, ist ein zweites Widerstandselement im Referenznetzwerk vorgesehen. Das im Referenzstrompfad angeordnete zweite Widerstandselement ist mit dem Referenztransistor und einer Versorgungsspannung verbunden.

Vorzugsweise ist der Widerstand des zweiten Widerstandselements derart ausgelegt, dass es einen über Zuleitungen verursachten Spannungsabfall im Laststrompfad durch einen entsprechenden Spannungsabfall über dem zweiten Widerstandselement im Referenzstrompfad kompensiert.

Durch eine bevorzugte Ausgestaltung ist vorgesehen, dass die Schaltvorrichtung ein kapazitives Element aufweist. Ein derartiges kapazitives Element ist beispielsweise ein MIM-Kondensator, eine MOS-Diode oder ein Transistor der als MOS-Diode verschaltet ist. Das kapazitive Element ist mit dem Steuereingang des Ausgangstransistors verbunden und zur Kompensation des Verschiebungsstroms durch den ersten Schalttransistor mit einem zum Steuersignal des ersten Schalttransistors invertierten Signal beaufschlagt. Im Idealfall heben sich der Verschiebungsstrom durch den ersten Schalttransistor und der Verschiebungsstrom durch das kapazitive Element gerade auf.

Gemäß einer anderen vorteilhaften Ausgestaltung ist der Stromspiegel als Kaskodenstromspiegel ausgebildet. Im Referenzstrompfad ist ein weiterer Transistor angeordnet der mit dem Referenztransistor zu einer Kaskodenschaltung in Reihe geschaltet ist. Im Laststrompfad ist ein weiterer Ausgangstransistor angeordnet der mit dem Ausgangstransistor zu einer Ausgangskaskodenschaltung in Reihe geschaltet ist. Die Steuereingänge der weiteren Transistoren, also des weiteren Ausgangstransistors und des weiteren Referenztransistors sind vorzugsweise mit einer Spannungsquelle derart verbunden, dass die weiteren Transistoren in Gate-Schaltung bzw. Baseschaltung betrieben sind.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen:
- Fig. 1: ein erstes Ausführungsbeispiel einer Treiberschaltung,
- Fig. 2: ein zweites Ausführungsbeispiel einer Treiberschaltung,
- Fig. 3: ein drittes Ausführungsbeispiel einer Treiberschaltung,
- Fig. 4: ein viertes Ausführungsbeispiel einer Treiberschaltung, und
- Fig. 5: ein fünftes Ausführungsbeispiel einer Treiberschaltung.

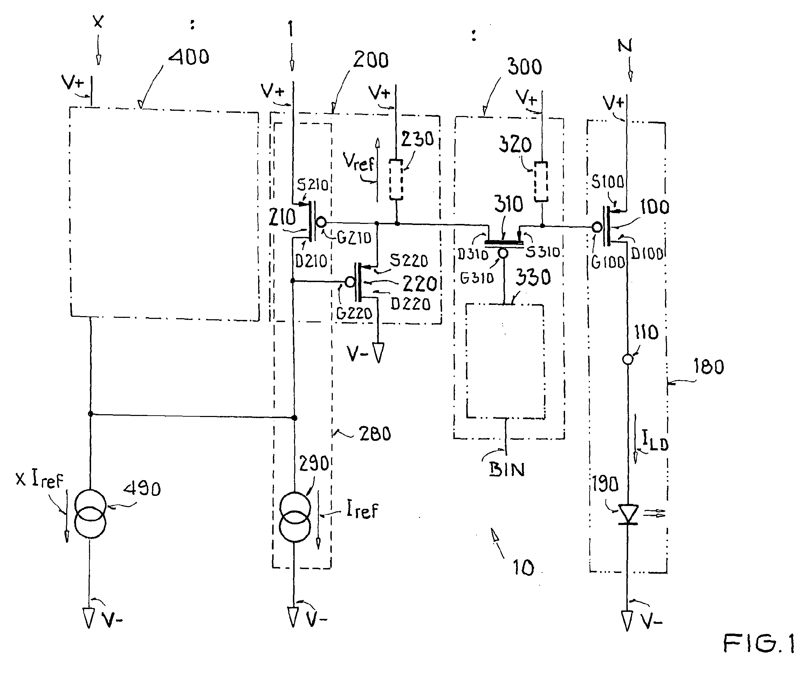

Fig. 1 zeigt eine Treiberschaltung 10. Eine derartige Ausgangsstufe 10 zusammen mit einem Pulsgenerator wird vorzugsweise für die Ansteuerung von einer Laserdiode 190 verwendet. Laserdioden mit unterschiedlichen Wellenlängen der emittierten Lichtleistung werden zum Lesen/Schreiben von Informationen von/auf optischen Speichermedien (CD - Compact Disc / DVD - Digital Versatile Disk) benötigt. Die wünschenswerten hohen Speicherdichten der Medien in Verbindung mit einer hohen Schreib- und Lesegeschwindigkeit erfordern die Erzeugung von präzisen Stromimpulsen für die Laserdioden. Dabei bezieht sich die Präzision auf die zeitliche Genauigkeit als auch auf die Kurvenform der Impulse, wie beispielsweise ein Überschwingen (overshoot), Klingeln (ringing), Amplitudengenauigkeit usw. Die Form des Signals der Strompulse für die Laserdiode 190 ist dabei maßgeblich von dem Aufbau der Treiberschaltung 10 abhängig.

Mittels eines Stromspiegels in CMOS-Technologie können die Anstiegs- und Abfallzeiten sowie die Einschwingzeiten der Impulse für eine spezifische Signalamplitude des Impulses optimiert werden. Die Anstiegs- und Abfallseiten und die Einschwingzeiten mittels eines Stromspiegels in CMOS-Technologie sind jedoch stark stromabhängig. So ist eine Optimierung eines Stromspiegels in CMOS-Technolgie mittels der Transistorgeometrien und des Übersetzungsfaktors N für eine spezifische Stromstärke beispielsweise 200 mA möglich. Jedoch kann erst auf der Basis der Treiberschaltung 10 gemäß der Figur 1 mit den heutigen zur Verfügung stehenden CMOS-Technologien eine befriedigende Lösung gefunden werden, welche den Anforderungen für den Einsatz unterschiedlicher Laserströme für die Anforderungen unterschiedlicher Laufwerke wie CD, DVD, BlueRay oder HD-DVD erreicht werden. Bei einigen dieser Anwendungen werden Stromimpulse mit mehreren 100 mA Stärke sowie Anstiegs- und Abfallzeiten unter einer Nanosekunde benötigt.

Die Treiberschaltung 10 gemäß dem Ausführungsbeispiel der Figur 1 weist den Vorteil von sehr geringen Anstiegs- und Abfallzeiten des Laserstroms I_{LD} auf. Weiterhin kann die Einschalt- und Ausschaltzeit des Stromimpulses für unterschiedliche Signalamplituden des Laserstroms I_{LD} separat eingestellt werden. Im Ausführungsbeispiel der Figur 1 kann eine hohe Verstärkung des Stromspiegels ohne wesentlichen Einfluss auf die Anstiegs- und Abfallgeschwindigkeit des Ausgangsstromes eingestellt werden. Dadurch kann ein hohes Verhältnis zwischen Ausgangsstrom und Referenzstrom erreicht werden, so dass als überraschender Effekt ein erhöhter Wirkungsgrad erzielt wird.

Figur 1 weist einen Stromspiegel mit dem Ausgangstransistor 100 und einem Referenztransistor 210 als Spiegeltransistoren auf. 1 : N ist dabei der geometrische Skalierungsfaktor zwischen den beiden Spiegeltransistoren 100 und 210. Beispielsweise beträgt der geometrische Skalierungsfaktor N = 10. Der Ausgangstransistor 100 ist mit dem Referenztransistor 210 über die Schaltvorrichtung 300 verbunden. Im eingeschalteten Zustand verbindet die Schaltungsvorrichtung 300 das Gate G100 des Ausgangstransistors 100 mit dem Gate G210 des Referenztransistors 210. Hingegen trennt die Schaltvorrichtung 300 die beiden Gates G100 und G210 im ausgeschalteten Zustand.

Der eingeschaltete Zustand und der ausgeschaltete Zustand werden dabei in Abhängigkeit von digitalen Daten am digitalen Dateneingang BIN gesteuert. Der Laststrom I_{LD} der durch die Laserdiode 190 fließt ist dabei nach Art einer Proportionalität von einem Referenzstrom Iref abhängig. Im Ausführungsbeispiel der Figur 1 sind der Ausgangstransistor 100 und der Referenztransistor 210 als PMOS-Feldeffekttransistoren ausgebildet. Das Übersetzungsverhältnis 1 : N und damit die Proportionalität zwischen dem Laststrom I_{LD} und dem Referenzstrom Iref gleicht daher dem Verhältnis der Kanalweite des Ausgangstransistors 100 zur Kanalweite des Referenztransistors 210.

Zum Treiben des Laststromes I_{LD} ist der Ausgangstransistor 100 in einem Laststrompfad 180 zusammen mit der Last 190 angeordnet. Die Treiberschaltung 10 ist vorzugsweise monolytisch auf einem Halbleiterchip integriert, hingegen ist die Last 190 üblicherweise off-chip. Die Last 190 wird mit der Treiberschaltung 10 somit mit dem Ausgangstransistor 100 über einen Lastanschluss 110 beispielsweise in Form eines metallischen Pins oder eines Pads verbunden.

Der Referenztransistor 210 ist in einem Referenzstrompfad 280 zusammen mit einer Stromquelle 290 angeordnet, wobei die Stromquelle 290 den Referenzstrom Iref bereitstellt. Dabei fließt unabhängig von dem am digitalen Dateneingang BIN anliegenden digitalen Signal ein Referenzstrom Iref von einer positiven Versorgungsspannung V+ über die Drain-Source-Strecke des Referenztransistors 210 und über die Stromquelle 290 zu einer gegenüber der positiven Versorgungsspannung V+ negativen Versorgungsspannung V-, die beispielsweise eine Masse darstellt.

Der Referenztransistor 210 ist Bestandteil eines Referenznetzwerks 200 in dem weitere Bauelemente 220, 230 vorgesehen sind. Als Bestandteil des Referenznetzwerkes 200 ist ein PMOS-Feldeffekttransistor 220 vorgesehen dessen Gate G220 im Ausführungsbeispiel der Figur 1 mit dem Referenzstrompfad 280 und mit dem Drain-Anschluss des Referenztransistors 210 und mit der Stromquelle 290 unmittelbar verbunden ist. Der Source-Anschluss S220 des PMOS-Feldeffekttransistors 220 ist mit dem Gate G210 des Referenztransistors 210 verbunden. Der Drain-Anschluss D220 des PMOS-Feldeffekttransistors 220 ist mit der negativen Versorgungsspannung V- verbunden.

Der PMOS-Feldeffekttransistor 220 ist somit als Sourcefolger beschaltet und weist einen geringen Ausgangswiderstand auf. Hierdurch wird der Vorteil erzielt, dass Lastschwankungen am Gate G210 des Referenztransistors 210 zu einer geringeren Schwankung des Potentials am Gate-Anschluss G210 des Referenztransistors 210 führen. Für den als Sourcefolger beschalteten PMOS-Feldeffekttransistor 220 ist weiterhin eine Widerstandsvorrichtung 230 vorgesehen, der mit der Source S220 des PMOS-Feldeffekttransistors 220 und der positiven Versorgungsspannung V+ verbunden ist. Durch diese Beschaltung fällt über der Widerstandsvorrichtung 230 eine mittels des Referenzstromes Iref einstellbare Referenzspannung Uref ab. Von dieser Referenzspannung Uref ist somit auch der Laststrom I_{LD} abhängig.

Die Schaltvorrichtung 300 weist im Ausführungsbeispiel der Figur 1 einen Schalttransistor 310 mit einem Gate-Anschluss G310, einem Drain-Anschluss D310 und einem Source-Anschluss S310 auf. Der Schalttransistor 310 ist im Ausführungsbeispiel der Figur 1 als PMOS-Feldeffekttransistor ausgebildet. Der Steueranschluss G310 des Schalttransistors 310 ist mit einer Signalformungsvorrichtung 330 verbunden, die das am Gate G310 anliegende Signal, insbesondere die Pulsform ausgibt. Mittels der Signalformungsvorrichtung 330 kann das Steuersignal für den Steuereingang G310 des Schalttransistors 310 für die verschiedenen Anforderungen unterschiedlicher Laser und deren Anwendungen unterschiedlichen Laufwerken gesteuert werden.

Weiterhin weist die Schaltvorrichtung 300 ein Bauelement 320 auf, das mit dem Steuereingang G100 des Ausgangstransistors 100 und mit der Versorgungsspannung V+ verbunden ist. Dieses Bauelement 320 ist beispielsweise ein Widerstand, der als auch pull-up Widerstand bezeichnet werden kann. Alternativ ist das Bauelement 320 ein steuerbares Bauelement wie beispielsweise ein Transistor.

Im abgeschalteten Zustand ist der Schalttransistor 330 offen. In diesem Zustand wird abhängig vom Referenzstrom Iref eine Referenzspannung Vref aufgebaut. Das Referenznetzwerk 200 bildet einen Regelkreis mit den Transistoren 220 und 210, dessen Verstärkung (beim Fehlen eines Dämpfungsnetzwerkes 400) der offenen Schleife wesentlich vom Innenwiderstand der Referenzstromquelle 290 bestimmt wird. Durch das Anschalten des Ausgangstransistors 100 über den Schalttransistor 310 erfährt der Regelkreis eine starke Störung, welche zu einem Einschwingvorgang führt. Der Einschwingvorgang führt in der Regel zu einem - unerwünschten - starken Überschwingen im Ausgangsstrom/Laststrom I_{LD} und Referenzstrom Iref mit anschließendem Abklingen (gedämpfte Schwingung).

Das Einschwingverhalten von Regelkreisen wird durch den Verstärkungs- und Phasengang des Regelkreises festgelegt. Damit ein Einschwingen ohne Überschwingen stattfindet, muss die so genannte Phasenreserve mindestens 90° betragen. Durch Veränderung der Impedanz der Referenzstromquelle 290 lässt sich somit das Einschwingverhalten beeinflussen. Da im Ausführungsbeispiel der Fig. 1 der Verstärkungs- und Phasengang der Regelschleife stark von der Höhe des Laststromes I_{LD} /Referenzstromes Iref und damit von der Höhe des Stromimpulses für die Laserdiode abhängen, erfolgt die Dämpfung überraschenderweise nicht über ein fest definiertes Dämpfungsglied - wie beispielsweise eine Serienschaltung von Kapazität und Widerstand, sondern durch ein Dämpfungsnetzwerk 400, das mit dem Referenzstrompfad 280 und einer weiteren Stromquelle 490 verbunden ist.

Vorzugsweise ist das Dämpfungsnetzwerk als Nachbildung des Referenznetzwerks ausgebildet. Das Dämpfungsnetzwerk 400 ist vorzugsweise in gleicher Weise wie das Referenznetzwerk 200 aufgebaut. Die Transistoren werden mit gleicher Stromdichte in beiden Netzwerken 200 und 400 betrieben. Da das Dämpfungsnetzwerk 400 (im Gegensatz zum Referenznetzwerk 200) keinen großen Ausgangstransistor treiben muss, ist sein Einschwingverhalten schnell bzw. bildet einen äquivalenten Dämpfungswiderstand, welcher den wirkenden Innenwiderstand der Referenzstromquelle 290 durch die Parallelschaltung des Dämpfungsnetzwerks 400 zur Referenzstromquelle 290 reduziert. Durch die Reduktion der Schleifenverstärkung des Regelkreises des Referenznetzwerkes 200 wird die Stabilität der Treiberschaltung 10 erhöht und das Überschwingen reduziert.

Somit wird bewirkt, dass das durch die Treiberschaltung 10 selbst verursachte, ungewünschte Überschwingen des Laststroms I_{LD} vermindert bzw. ganz unterdrückt wird. Dabei zeigt sich der überraschende Effekt, dass im Gegensatz zu einer Anordnung aus Widerständen und Kapazitäten als passive Dämpfungsglieder das Dämpfungsnetzwerk 400 wirkungsvoller ist, da es in seinem Verhalten in analoger Weise von dem Referenzstrom Iref beeinflusst wird.

Vorzugsweise, jedoch nicht notwendigerweise, stehen die Bauelemente des Referenznetzwerks 200 und des Dämpfungsnetzwerks 400 in einer geometrischen Beziehung. Die Bauelemente sind dabei vorzugsweise derart ausgebildet, dass die Stromdichten in dem Referenznetzwerk 200 und dem Dämpfungsnetzwerk einander gleichen. Die geometrische Proportionalität ist dabei durch den Faktor X ausgedrückt.

Die Treiberschaltung 10 des Ausführungsbeispiels der Figur 1 lässt sich durch die stationären Zustände "ein" und "aus", sowie das Verhalten beim Einschalten und Ausschalten beschreiben. Im stationären Zustand "ein" ist die Schaltvorrichtung 300 niederohmig, indem der Schalttransistor 310 eingeschaltet ist. Die Referenzspannung Vref liegt somit nicht nur an dem Gate G210 des Referenztransistors 210 sondern auch an dem Gate G100 des Ausgangstransistors 100 an. Das Referenznetzwerk 200 mit dem Referenztransistor 210 bildet nun zusammen mit dem Ausgangstransistor 300 einen Stromspiegel. In dem PMOS-Feldeffekttransistoren 100 und 210 liegen Stromdichten vor, die sich gleichen.

Bedingt durch das geometrische Verhältnis der Kanalweiten zwischen dem Ausgangstransistor 100 und dem Referenztransistor 210 ist der Laststrom I_{LD} proportional zum Referenzstrom Iref. Im "aus"-Zustand ist die Schalteinrichtung 300 hochohmig, in dem der Schalttransistor 310 abgeschaltet ist. Der Steuereingang G100 des Ausgangstransistors 100 wird hierdurch mit dem Potential der positiven Versorgungsspannung V+ beaufschlagt, so dass der Ausgangstransistor 100 sperrt. Somit ist auch der Laststrom I_{LD} abgeschaltet, wenn die Gate-Kapazität über den Widerstand 320 entladen ist.

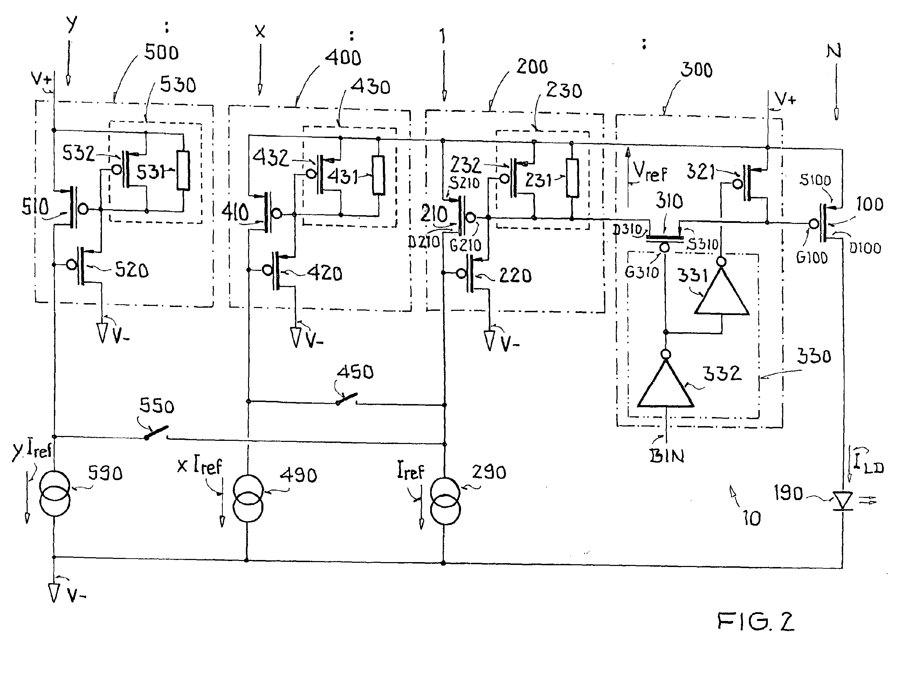

Ein weiteres Ausführungsbeispiel einer Treiberschaltung 10 ist in der Figur 2 dargestellt. Die Schaltvorrichtung 300 weist zusätzlich zu dem ersten Schalttransistor 310 einen zweiten Schalttransistor 321 auf. Die Signalformungsvorrichtung 330 weist einen ersten Inverter 331 und einen zweiten Inverter 332 auf, die beispielsweise als digitale CMOS-Inverter ausgebildet sind und die digitalen Daten, die am digitalen Dateneingang BIN anliegen, invertieren. Die Signalformungseinrichtung 330 weist dabei zwei Ausgänge auf, wobei ein erster Ausgang mit dem ersten Schalttransistor 310 und ein zweiter Ausgang mit dem zweiten Schalttransistor 321 verbunden sind.

An dem Steuereingang des zweiten Schalttransistors 321 wird dabei das zum Schalttransistor 310 invertierte Steuersignal bereitgestellt, so dass der erste Schalttransistor dann leitet, wenn der zweite Schalttransistor 321 sperrt und so dass der zweite Schalttransistor 321 dann leitet, wenn der erste Schalttransistor 310 sperrt. Die Widerstandsvorrichtung 230 die an der Source des PMOS-Feldeffekttransistor 220 wirkt, weist im Ausführungsbeispiel der Figur 2 einen Widerstand 231 und einen insbesondere als MOS-Diode geschalteten PMOS-Feldeffekttransistor 232 in Parallelschaltung auf.

Zusätzlich zu einem ersten Dämpfungsnetzwerk 400 ist ein zweites Dämpfungsnetzwerk 500 vorgesehen. Jedes Dämpfungsnetzwerk 400, 500 ist jeweils mit einer Stromquelle 490 bzw. 590 verbunden. Weiterhin ist das erste Dämpfungsnetzwerk 400 über einen Schalter 450 mit dem Referenzstrompfad verbunden. Weiterhin ist das zweite Dämpfungsnetzwerk 500 über einen zweiten Schalter 550 ebenfalls mit dem Referenzstrompfad verbunden. Die Schalter 450 und 550 können beispielsweise durch einen PMOS-Feldeffekttransistor realisiert werden. Das Ausführungsbeispiel der Figur 2 verwendet dabei beispielhaft zwei Dämpfungsnetzwerke 400 und 500 die über die Schalter 450 und 550 nach Bedarf zugeschaltet werden können.

Selbstverständlich kann auch eine größere Anzahl von Dämpfungsnetzwerken verwendet werden. Vorzugsweise weisen beide Dämpfungsnetzwerke 400 und 500 eine zu dem Referenznetzwerk 200 entsprechende Verschaltung von Bauelementen auf. Um vorzugsweise gleiche Stromdichten in dem Referenznetzwerk 200 und in den beiden Dämpfungsnetzwerken 400 und 500 zu erzielen, sind die Geometrien der Bauelemente der Netzwerke 200, 400 und 500 zueinander skaliert. Hierzu weist das erste Dämpfungsnetzwerk 400 einen Skalierungsfaktor von X und das zweite Dämpfungsnetzwerk einen Skalierungsfaktor von Y auf.

Beide der Dämpfungsnetzwerke weisen einen zum Referenztransistor 210 entsprechenden Transistor 410 bzw. 510 auf. Ebenfalls weisen beide Dämpfungsnetzwerke 400, 500 einen zum PMOS-Feldeffekttransistor 220 korrespondierenden PMOS-Feldeffekttransistor 420 bzw. 520 auf. Auch die Widerstandsvorrichtung 230 mit dem Widerstand 231 und dem PMOS-Feldeffekttransistor 232 findet ein Pendant in den Dämpfungsnetzwerken mit der Widerstandsvorrichtung 430 und 530, die jeweils einen Widerstand 431 und 531 und einen PMOS-Feldeffekttransistor 432 und 532 aufweisen.

Die mit dem jeweiligen Dämpfungsnetzwerk 400 bzw. 500 verbundene Stromquelle 490 bzw. 590 ist an die Skalierung X bzw. Y angepasst, so dass ein Strom xlref von der Stromquelle 490 und ein weiterer Strom ylref von der Stromquelle 590 bereitgestellt werden. Diese Ströme xlref und ylref können bei gleichen Skalierungsfaktoren X = Y ebenfalls gleich sein oder bei unterschiedlichen Skalierungsfaktoren X ≠ Y entsprechend voneinander abweichen.

Der Einschaltvorgang lässt sich an dem Ausführungsbeispiel der Figur 2 wie folgt erläutern. Der Schalttransistor 321 wird zunächst über das logische Signal am digitalen Dateneingang BIN gesperrt. Danach wird der erste Schalttransistor 310 leitfähig geschaltet und damit die Gate-Source-Spannung des Ausgangstransistors 100 auf die Referenzspannung Vref gebracht. Aufgrund der geometrischen Größe des Ausgangstransistors 100 und der damit verbundenen größeren Gate-Kapazität als die des Referenztransistors 210 muss der Ladestrom für das Gate G100 des Ausgangstransistors 100 für ein schnelles Einschalten hoch sein.

Dieser Ladestrom wird auch als Verschiebungsstrom bezeichnet, da durch diesen die Gate-Kapazität des Ausgangstransistors 100 aufgeladen wird. Der Ladestrom führt zu einem Absinken des Gate-Potentials und damit der Referenzspannung Uref bezogen auf die Versorgungsspannung V+. Damit wird auch der Drain-Strom durch den Referenztransistor 210 kleiner was wiederum zu einer Aufsteuerung des PMOS-Feldeffekttransistors 220 führt. Demzufolge bilden die Transistoren 210 und 220 einen Regelkreis.

Aufgrund der großen Gate-Kapazität des Ausgangstransistors 100 wird das Einschwingen dieser Regelschaltung auf einen stationären Wert erst nach einem Überschwingen (overshoot) erreicht. Die Schaltung des Ausführungsbeispiels der Figur 2 benötigt daher als zusätzliche Maßnahme je nach Laserdiodentyp zumindest eines der Dämpfungsnetzwerke 400 oder 500, die die Regelschwingung dämpfen.

Zum Ausschalten wird der erste Schalttransistor 310 gesperrt und der zweite Schalttransistor 321 eingeschaltet. Dabei ist es zweckmäßig zuerst den ersten Schalttransistor 310 zu sperren und danach den zweiten Schalttransistor 321 einzuschalten. Dadurch wird die Teilschaltung aus Referenznetzwerk 200 und Stromquelle 290 zur Erzeugung der Referenzspannung Vref möglichst wenig belastet. Hierzu verzögert im Ausführungsbeispiel der Figur 2 der erste Inverter 331 der Signalformungseinrichtung 330 das Steuersignal für den zweiten Schalttransistor gegenüber dem Steuersignal für den ersten Transistor 310.

Im Ausführungsbeispiel der Figur 2 stehen die Bauelemente des Referenznetzwerks 200 und die Bauelemente des jeweiligen Dämpfungsnetzwerkes 400 bzw. 500 in einer geometrischen Beziehung. Die geometrische Beziehung der Bauelemente ist dabei derart, dass die Stromdichten in Netzwerken 200, 400 und 500 jeweils gleich sind. Ein Proportionalitätsfaktor von X = 0,5 bedeutet beispielsweise, dass die Kanalweite des Transistors 410 nur das 0,5-fache der Kanalweite des Referenztransistors 210 ist. Dies gilt entsprechend auch für den Widerstand 431, der die Hälfte des Widerstandswerts des Widerstands 231 aufweist.

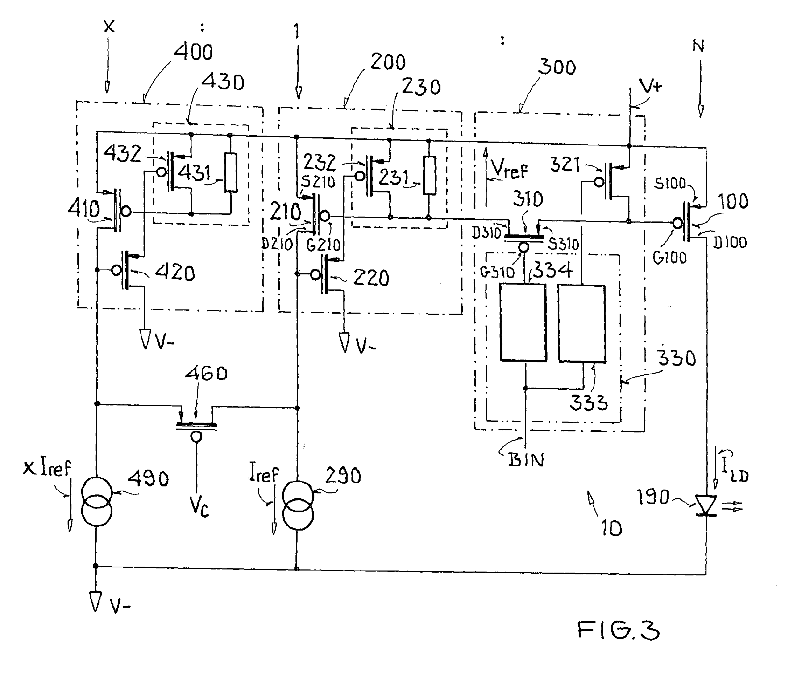

In Figur 3 ist ein weiteres Ausführungsbeispiel einer Treiberschaltung 10 dargestellt. Der PMOS-Feldeffekttransistor 460 wird dabei als steuerbarer (aktiver) Widerstand verwendet. Hierzu wird eine analoge Steuerspannung VC an den PMOS-Feldeffekttransistor 460 angelegt. Mittels der analogen Steuerspannung VC ist es möglich die Dämpfung durch das Dämpfungsnetzwerk 400 zu verändern, indem durch den veränderlichen Widerstand der Drain-Source-Strecke des PMOS-Feldeffekttransistors 460 der Dämpfungsgrad kontinuierlich eingestellt werden kann.

Auch eine Kombination der Ausführungsbeispiele der Figur 2 und der Figur 3 sind denkbar, wobei sowohl ein kontinuierliches Steuerelement 460 wie auch ein diskretes Steuerelement 450, 550 verwendet werden. Die zeitliche Abfolge von Ein- und Ausschalten der Schalttransistoren 310 und 321 beeinflusst im hohen Maße auch das Einschwingverhalten des Ausgangsstroms I_{LD}. Im Ausführungsbeispiel der Figur 3 sind daher Impulsformer 333 und 334 vorgesehen mittels derer die Steuersignale für die Schalttransistoren 310 und 321 optimiert werden können. Vorzugsweise sind die Impulsformer 333 und 334 dabei derart ausgebildet, dass diese an den beiden Ausgängen im eingeschwungenen Zustand zueinander komplementäre Signale bereitstellen.

Die dargestellten Impulsformer 333, 334 können je nach geforderter Applikation feste oder durch eine Einstellung unterschiedliche Signalverzögerungen erzeugen. Beispielsweise kann es wünschenswert sein, dass die steigende Flanke aus 333 vor der fallenden Flanke aus 334 erscheint und die steigende Flanke aus 334 vor der fallenden Flanke aus 333 auftritt. Vorteilhafterweise dien die Impulsformer 333 und 334 ausgebildet steigende und fallende Flanken unterschiedlich zu verzögern.

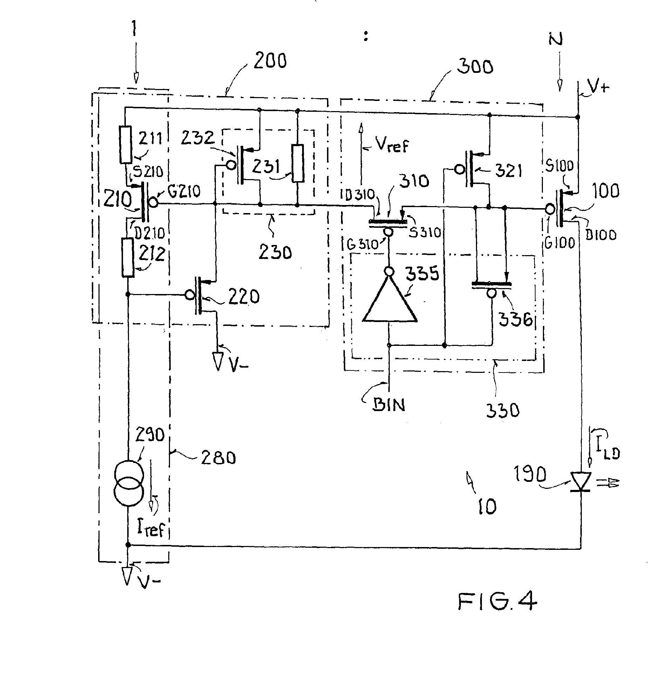

Ein weiteres Ausführungsbeispiel einer Treiberschaltung 10 ist in der Figur 4 dargestellt. Im Laststrompfad 280 ist ein erster Widerstand 212 angeordnet, so dass der Referenzstrom Iref über den Referenztransistor 210 über den ersten Widerstand 212 und über die Stromquelle 290 fließt. Dabei ist in Betracht gezogen, dass die Stromübersetzung zwischen dem Referenzstrom Iref und dem Laststrom I_{LD} nur dann optimal ist, wenn die Drain-Source-Spannung von den Transistoren 100 und 210 möglichst gleich ist. Dies ist jedoch aufgrund des stromabhängigen Spannungsabfalls am Lastelement - im Ausführungsbeispiel der Figur 4 der Laserdiode 190 - nur näherungsweise zu erreichen.

Der in dem Referenznetzwerk 200 in der Drain-Leitung von dem Referenztransistor 210 befindliche erste Widerstand 212 führt zu einer stromabhängigen Verringerung der Drain-Source-Spannung des Referenztransistors 210. Damit kann erreicht werden, dass sich auf für den Referenztransistor 210 die Drain-Source-Spannung mit steigendem Strom verringert und damit die Stromübersetzung 1 zu N näherungsweise konstant gehalten werden kann.

Eine Abhängigkeit des Übersetzungsverhältnisses N von dem Laststrom I_{LD} wird durch unvermeidliche Spannungsabfälle auf Verbindungsleitungen der integrierten Schaltung verursacht. Der im Ausführungsbeispiel der Figur 4 zusätzlich in den Referenzstrompfad 280 eingefügte Widerstand 211 kompensiert diesen Effekt, indem der dort erzeugte Spannungsabfall die Gate-Source-Spannung des Ausgangstransistors 100 stromabhängig erhöht und damit den Abfall des Laststroms I_{LD} entgegenwirkt. Bevorzugt werden zu den Widerständen 212 und 211 entsprechende Widerstände auch in den Dämpfungsnetzwerken 400, 500 vorgesehen und mit dem entsprechenden Skalierungsfaktor X bzw. Y skaliert.

In Figur 4 ist eine MOS-Kapazität 336 vorgesehen, die beispielsweise durch einen PMOS-Feldeffekttransistor mit verbundener Source und Drain realisiert werden kann. Die MOS-Kapazität 336 bildet dabei ein kapazitives Element, dessen Kapazitätswert vorzugsweise einem Kapazitätswert des ersten Schalttransistors 310 gleicht. Beim Einschalten des Schalttransistors 310 wird über die Kapazitäten des Schalttransistors 310 elektrische Ladung von der Ansteuerschaltung 330 auch auf das Gate des Ausgangstransistors 100 übertragen. Dies führt insbesondere bei kleinen Lastströmen I_{LD} zu einer zusätzlichen Überhöhung des Laststromes I_{LD}. Dieser Effekt wird durch die gegenphasig zu dem ersten Schalttransistor angesteuerte MOS-Kapazität 336 zumindest teilweise kompensiert. Bei idealer Dimensionierung wird die von Schalttransistor 310 während der Einschaltphase übertragene Ladung von der MOS-Kapazität 336 abgebaut.

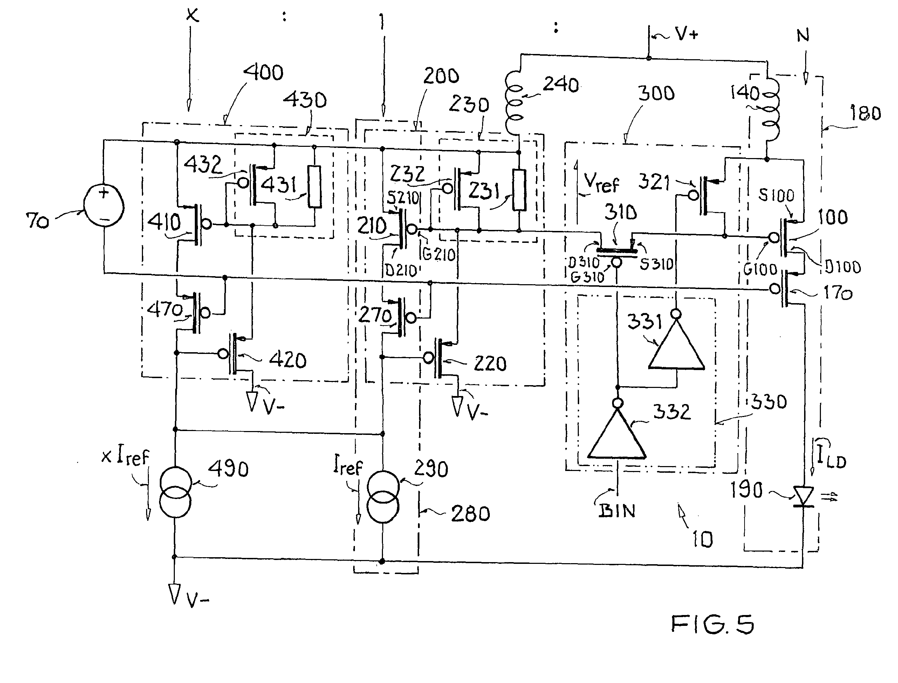

Ein weiteres Ausführungsbeispiel einer Treiberschaltung 10 ist in der Figur 5 dargestellt. Bei einer Ansteuerung hochohmiger Lasten beispielsweise einer blauen Laserdiode ist die Verwendung einer sogenannten Kaskodenschaltung vorteilhaft. Die Kaskodenschaltung reduziert den sogenannten Miller Effekt, welcher durch die Drain-Gate-Kapazität insbesondere des Ausgangstransistors 100 hervorgerufen wird. Durch die Kaskodenschaltung wird die Bandbreite der Schaltung größer, so dass schnellere Schaltvorgänge erzielt werden können. Zusätzlich wird die Spannungsabhängigkeit des Drain-Stroms durch den Ausgangstransistor 100 reduziert.

Zur Ausbildung der Kaskodenschaltung sind im Ausführungsbeispiel der Figur 5, die PMOS-Feldeffekttransistoren 170, 270 und 470 vorgesehen, deren Steuereingänge gemeinsam mit einer Spannungsquelle 70 verbunden sind. Alternativ sind auch andere Verschaltungen zur Bereitstellung eines Gate-Potentials des jeweiligen Transistors 170, 270, 470 möglich. Beispielsweise kann das Gate-Potential vom Referenzstrom Iref abgeleitet werden.

Die Transistoren 170, 270 und 470 sind in Gate-Schaltung betrieben. Der PMOS-Feldeffekttransistor 170 ist in Reihenschaltung mit dem Ausgangstransistor 100 verschaltet. Beide Transistoren 100, 170 sind im Laststrompfad 180 angeordnet. Der PMOS-Feldeffekttransistor 270 ist mit dem Referenztransistor 210 in Reihe geschaltet, wobei beide Transistoren im Referenzstrompfad 280 angeordnet sind. Vorzugsweise weisen die Transistoren 170, 270 und 470 entsprechend den Transistoren 100, 210 und 410 eine entsprechende Skalierung X : 1: N der Kanalweite auf.

Vorteilhafterweise mittels Bonddrähte werden die Induktivitäten 140 und 240 erzeugt. Die Induktivitäten der Bonddrähte und deren magnetische Kopplung beeinflussen die Impulsform des Laststromes I_{LD}. Dabei werden der Ausgangstransistor 100 und der Referenztransistor 210 über getrennte Bonddrähte 140 bzw. 240 mit der Versorgungsspannung V+ verbunden. Der bei schnellen Stromimpulsen im Ausgangstransistor 100 auftretende Spannungsabfall über die Bonddrahtinduktivität 140 führt zu einer Dämpfung von Überschwingen und Klingeln. Die Methode kann zusätzlich zu der Dämpfung durch das Dämpfungsnetzwerk 400 bzw. 500 angewendet werden. Durch die Kombination beider Dämpfungsmöglichkeiten mittels der Dämpfungsnetzwerke 400 und 500 und den Dämpfungsgliedern durch die Induktivitäten 140 und 240 kann der überraschende Effekt erzielt werden, dass das durch die Treiberschaltung 10 selbst verursachte Überschwingen, als auch das durch parasitäre Schwingkreis von Zuleitungen verursache Überschwingen separat kompensiert werden kann. Hierdurch kann der Dämpfungsgrad in weiten Grenzen verändert werden.

Die Erfindung ist dabei nicht auf die dargestellten Ausgestaltungsvarianten der Figuren 1 bis 5 beschränkt. Beispielsweise ist es möglich, dass weitere Dämpfungsnetzwerk 500 und die Schalter 450 und 550 auch in den Ausführungsbeispielen der Figuren 1, 3, 4 oder 5 vorzusehen. Weiterhin ist es möglich, den aktiven Widerstand 460 und/oder die Impulsformerstufe 333 bzw. 334 in den Ausführungsbeispielen der Figuren 1, 2, 4 oder 5 vorzusehen. Weiterhin ist es möglich zumindest einen der Widerstände 211 bzw. 212 in den Ausführungsbeispielen der Figuren 1, 2, 3 oder 5 vorzusehen. Auch ist es möglich, dass kapazitive Element 336 in einem der Ausführungsbeispiele 1, 2, 3 oder 5 vorzusehen. Ebenfalls ist es möglich die Kaskodenanordnung aus Figur 5 mit den Transistoren 120, 270 und 470 in einem der Ausführungsbeispiele der Figuren 1 bis 4 vorzusehen. Auch können auch die Induktivitäten 140 und 240 in einem der Ausführungsbeispiele bezüglich Figur 1 bis Figur 4 vorgesehen sein. Anstelle der in den Figuren 1 bis 5 dargestellten PMOS-Feldeffekftransistoren können alternativ oder in Kombination komplementäre Schaltungen oder Schaltungsteile mit NMOS-Feldeffekttransistoren verwendet oder verbunden werden.

### Bezugszeichenliste

- 10: Treiberschaltung
- 70: Spannungsquelle
- 100: Ausgangstransistor, MOS-Feldeffekttransistor
- 110: Lastanschluss
- 140, 240: Induktivität
- 170: weiterer Ausgangstransistor
- 180: Laststrompfad
- 190: Last, Laserdiode, Leuchtdiode
- 200: Referenznetzwerk
- 210: Referenztransistor, MOS-Feldeffekttransistor
- 211, 212, 230, 430, 530: Widerstandselement, Widerstand
- 220, 232, 270, 410, 420,: Transistor, MOS-Feldeffekttransistor
- 432,470,510,520,532 230, 320, 430, 530: Widerstandsvorrichtung
- 280: Referenzstrompfad
- 290, 490, 590: Stromquelle, Konstantstromquelle
- 300: Schaltvorrichtung
- 310, 321, 450, 550: Schalttransistor
- 330: Signalformungsvorrichtung
- 331, 332: analoger/digitaler Inverter
- 333, 334: Impulsformerstufe
- 336: kapazitives Element, MOS-Diode
- 400,500: Dämpfungsnetzwerk
- 460: einstellbarer Widerstand, MOS-Feldeffekttransistor
- D220, D310: Drain
- G100, G210, G220,: Gate
- G310 S220, S310: Source
- V+, V-: Versorgungsspannung
- Uref, Vref: Referenzspannung
- I_{LD}: Laststrom
- Iref: Referenzstrom
- xlref, ylref: Dämpfungsstrom
- BIN: digitaler Dateneingang
- N, X: Übersetzungsverhältnis, Spiegelfaktor, Skalierungsfaktor

## Patentansprüche

1. Treiberschaltung (10)
- mit zumindest einem Ausgangstransistor (100),
- mit einem Referenznetzwerk (200) mit zumindest einem Referenztransistor (210),
- mit einer Schaltvorrichtung (300), die mit dem Steuereingang (G100) des Ausgangstransistors (100) und mit dem Steuereingang (G210) des Referenztransistors (210) zur Ausbildung eines schaltbaren Stromspiegels verbunden ist,
- mit einer Stromquelle (290) zur Bereitstellung eines Referenzstromes (Iref) für einen Referenzstrompfad (280), wobei die Stromquelle (290) und der Referenztransistor (210) im Referenzstrompfad (280) angeordnet sind,
- mit einem Lastanschluss (110), wobei der Lastanschluss (110) und der Ausgangstransistor (100) in einem Laststrompfad (180) angeordnet sind, und
- mit zumindest einem Dämpfungsnetzwerk (400, 500), das mit dem Referenzstrompfad (290) verbunden oder verbindbar ist,
- bei der eine Verschaltung von Bauelementen des zumindest einen Dämpfungsnetzwerkes (400, 500) und eine Verschaltung von Bauelementen des Referenznetzwerkes (200) gleich sind.

2. Treiberschaltung (10) nach Anspruch 1, bei der die Bauelemente des zumindest einen Dämpfungsnetzwerks (400, 500) und des Referenznetzwerks (200) derart geometrisch ausgebildet sind, dass jeweilige Stromdichten im Dämpfungsnetzwerk (400, 500) und im Referenznetzwerk (200) gleich sind.

3. Treiberschaltung (10) nach einem der vorhergehenden Ansprüche,
- mit einem Steuerelement (450, 460, 550), das zur Einstellung einer Dämpfung durch das zumindest eine Dämpfungsnetzwerk (400, 500) mit dem Dämpfungsnetzwerk (400, 500) und dem Referenznetzwerk (200) verbunden ist.

4. Treiberschaltung (10) nach einem der vorhergehenden Ansprüche, bei der zumindest eine weitere Stromquelle (490, 590) mit dem Dämpfungsnetzwerk verbunden ist.

5. Treiberschaltung (10) nach einem der vorhergehenden Ansprüche, bei der das Referenznetzwerk (200) einen als Sourcefolger oder Emitterfolger verbundenen ersten Transistor (220) aufweist, dessen Steuereingang (G220) mit dem Referenzstrompfad (280) und dessen Source (S220) oder Emitter mit dem Steuereingang (G210) des Referenztransistors (210) verbunden sind.

6. Treiberschaltung (10) nach Anspruch 5, bei der der Steuereingang (G220) des ersten Transistors (220) des Referenznetzwerkes (200) mit der Stromquelle (290) verbunden ist.

7. Treiberschaltung (10) nach einem der vorhergehenden Ansprüche, bei der die Schaltvorrichtung (300) einen ersten Schalttransistor (310) aufweist, der mit dem Steuereingang (G100) des Ausgangstransistors (100) und mit dem Steuereingang (G210) des Referenztransistors (210) verbunden ist.

8. Treiberschaltung (10) nach Anspruch 7, bei der die Schaltvorrichtung (300) einen zweiten Schalttransistor (321) aufweist, der mit dem Steuereingang (G100) des Ausgangstransistors (100) und mit einer Versorgungsspannung (V+) verbunden ist.

9. Treiberschaltung (10) nach Anspruch 8,
- mit einer Signalformungsvorrichtung (330) zur Formung eines ersten Steuersignals und/oder eines zweiten Steuersignals für den ersten Schalttransistor (310) und/oder den zweiten Schalttransistor (321),
- bei der die Signalformungsvorrichtung (330) mit dem Steuereingang des ersten Schalttransistors (310) und/oder mit dem Steuereingang des zweiten Schalttransistors (321) verbunden ist.

10. Treiberschaltung (10) nach einem der Ansprüche 5 bis 9, bei der das Referenznetzwerk (200) ein erstes Widerstandselement (212) aufweist, das im Referenzstrompfad (280) angeordnet und mit dem Referenztransistor (210) und dem Steuereingang des ersten Transistors (220) verbunden ist.

11. Treiberschaltung (10) nach einem der vorhergehenden Ansprüche, bei der das Referenznetzwerk (200) ein zweites Widerstandselement (211) aufweist, das im Referenzstrompfad (280) angeordnet und mit dem Referenztransistor (210) und einer Versorgungsspannung (V+) verbunden ist.

12. Treiberschaltung (10) nach einem der vorhergehenden Ansprüche, bei der die Schaltvorrichtung (300) ein kapazitives Element (336) aufweist, das mit dem Steuereingang (G100) des Ausgangstransistors (100) verbunden und zur Kompensation des Verschiebungsstroms durch den ersten Schalttransistor (310) mit einem zum Steuersignal des ersten Schalttransistors (310) invertierten Signal beaufschlagt ist.

13. Treiberschaltung (10) nach einem der vorhergehenden Ansprüche,
- bei der im Referenzstrompfad (280) ein weiterer Transistor (270) angeordnet ist, der mit dem Referenztransistor (210) zu einer Kaskodeschaltung in Reihe geschaltet ist,
- bei der im Laststrompfad (180) ein weiterer Ausgangstransistor (170) angeordnet ist, der mit dem Ausgangstransistor (100) zu einer Ausgangs-Kaskodeschaltung in Reihe geschaltet ist,
- die Steuereingänge der weiteren Transistoren (170, 270) mit einer Spannungsquelle (70) derart verbunden sind, dass die weiteren Transistoren (170, 270) in Gate-Schaltung oder Basisschaltung betrieben sind.

14. Verfahren zum Betrieb einer Treiberschaltung (10), bei dem für eine vorgegebene Signalform eines zu treibenden Laststroms (I_{LD}) eine Dämpfung eingestellt wird,
indem ein Referenzstrompfad (280) eines schaltbaren Stromspiegels mittels zumindest eines Verbindungselementes (450, 460, 550) mit zumindest einem Dämpfungsnetzwerk (400, 500) für die jeweilige Signalform des zu treibenden Laststroms (I_{LD}) verbunden wird.

15. Verwendung
- eines mittels eines Schalttransistors (310) schaltbaren Stromspiegels mit einem eine Stromquelle (290) aufweisenden Referenzstrompfad (280) und einem Laststrompfad (180), wobei der Schalttransistor (310) eine Verbindung zwischen dem Referenzstrompfad (280) und dem Laststrompfad (180) schaltet, und
- zumindest eines mit dem Referenzstrompfad (280) und der Stromquelle (290) verbundenen oder verbindbaren Dämpfungsnetzwerkes (400, 500),
zur Einstellung der Signalform eines Laststromes (I_{LD}) durch den Laststrompfad (180).
